# EUROPÄISCHE PATENTSCHRIFT

(11) **EP 0 651 601 B1**
(45) Veröffentlichungstag und Bekanntmachung des Hinweises auf die Patenterteilung: **08.11.2000**
(21) Anmeldenummer: 94115647.3
(22) Anmeldetag: 05.10.1994
(51) Int. Cl.: H05K 3/34, G03F 7/027

(54) **Photopolymerisierbares Gemisch und Verfahren zur Herstellung von Lötstopmasken**
Photopolymerisable mixture and process for manufacturing solder masks
Mélange photopolymérisable et procédé de fabrication de masques de soudure

(30) Priorität: 28.10.1993 DE 4336901
(43) Veröffentlichungstag der Anmeldung: 03.05.1995
(73) Patentinhaber: DU PONT DE NEMOURS (DEUTSCHLAND) GMBH, 61343 Bad Homburg v.d.H. (DE); E.I. DU PONT DE NEMOURS AND COMPANY, Wilmington, DE 19808 (US)
(72) Erfinder: Schober, Dr. Manfred, D-63065 Offenbach (DE); Mann, Gabriele, D-63263 Neu-Isenburg (DE); Bartmann, Dr. Dieter, D-63065 Offenbach (DE); Hinz, Lucyna, D-63303 Dreieich (DE); Fey, Dr. Thomas, D-55128 Mainz (DE)

(56) Entgegenhaltungen:
- EP-A- 0 063 304
- EP-A- 0 384 226
- EP-A- 0 418 733
- EP-A- 0 549 946

## Beschreibung

Die vorliegende Erfindung betrifft ein photopolymerisierbares Gemisch zur Herstellung von Lötstopmasken enthaltend ein Bindemittel, ein photopolymerisierbares Monomer, einen Photoinitiator, eine Verbindung mit mindestens zwei thermisch reaktiven Gruppen, einen Füller, ein Gießhilfsmittel und als Mattierungsmittel ein Kieselsäuregel mit definierter Ölzahl, Partikelgröße, Porenvolumen und Oberflächen-pH-Wert.

Bevor ein- oder doppelseitig bestückte oder auch durchkontaktierte, in reiner Kupferschaltung hergestellte Leiterplatten einem Lötprozeß unterworfen werden, wird bekanntermaßen eine Lötstopmaske aufgebracht. Diese Lötstopmaske schützt die gedruckten Schaltungen während des Lötprozesses und bleibt auch als permanente Schutzschicht auf der fertigen Leiterplatte. Die Anforderungen an solche Lötstopmasken sind demnach sehr hoch, da sie sowohl den hohen Temperaturen und agressiven Reagenzien der Verarbeitungsprozesse standhalten und auch resistent gegen Feuchtigkeit sein müssen aber andererseits auch flexibel genug sein müssen, um bei mechanischer Beanspruchung nicht zu brechen oder sich von der Platte zu lösen.

Lötstopmasken können sowohl als Trockenfilm auf die Leiterplatte laminiert werden oder auch als flüssiger Lack im Siebdruckverfahren oder mittels Vorhanggießen aufgebracht werden. Die flüssigen Lacke sind vorteilhafter, da sie keine Vakuumlamination erfordern und die immer feiner werdenden Linie der gedruckten Schaltungen exakter abdecken. Dies gilt insbesondere für das Vorhanggießverfahren wie es z.B. in der EP-B 0 002 040 beschrieben ist.

Geeignete photopolymerisierbare Gemische sind in EP-B 0 075 537, DE-A 39 31467, EP-A 0 549 946, EP-A 0 424 866 und EP-A 0 233 623, beschrieben.
Als Füllstoffe werden üblicherweise u.a. Talk oder pyrogene und gefällte Kieselsäuren verwendet. Auch die nach dem speziellen Verfahren der EP-A 0 384 226 hergestellten Kieselsäuren können in UV-härtbaren Schichten verwendet werden.
In der EP-B 0 073 444 und der EP-B 0 063 304 werden photopolymerisierbare Gemische beschrieben, die zusätzlich eine Verbindung mit zwei Epoxygruppen oder anderen thermisch reaktiven Gruppen zur Vernetzung der Carboxylgruppen des Bindemittels enthalten, so daß die Lötstopmasken nach der Entwicklung nachgehärtet werden können,

Nachteilig an diesen bekannten photopolymerisierbaren Gemischen für Lötstopmasken ist, daß Benetzungsstörungen beim Gießauftrag auftreten, wodurch sich Unregelmäßigkeiten der aufgebrachten Lackschicht ergeben. Durch Zugabe spezieller Gießhilfsmittel lassen sich diese Schwierigkeiten nur zum Teil beheben, und es treten zudem weitere Nachteile durch diese Zusätze auf wie z.B. Ausschwitzen und Ausgasen dieser Stoffe bei hohen Temperaturen. Die fertigen Lötstopschichten zeigen daher Bläschen und die sogenannte Orangenhaut.

Aufgabe der vorliegenden Erfindung ist es, ein photopolymerisierbares Gemisch und ein Verfahren bereitzustellen, die zur Herstellung von thermisch nachhärtbaren Lötstopmasken mit einer matten Oberfläche geeignet sind, wobei die photopolymerisierbaren Gemische ein verbessertes Auftragsverhalten während des Herstellungsverfahrens zeigen und eine gute Filmbildung aufweisen sollen.

Diese Aufgabe wird gelöst durch ein photopolymerisierbares Gemisch gemäß Anspruch 1 und ein Verfahren zur Herstellung einer Lötstopmaske gemäß Anspruch 12.

Ein wichtiges Kriterium der erfindungsgemäßen Mattierungsmittel ist, daß nur Kieselsäuregele verwendet werden können. Sowohl Fällungskieselsäuren als auch pyrogene Kieselsäuren sind ungeeignet, da sie Gieß- und Benetzungsstörungen verursachen, selbst wenn sie ähnliche Spezifikationen wie die erfindungsgemäßen Kieselsäuregele aufweisen.

Die als Mattierungsmittel verwendeten erfindungswesentlichen Kieselsäuregele weisen eine Ölzahl von 200 - 360g/100g, bevorzugt 300 - 340g/100g auf. Die Ölzahl gibt die Menge Öl an, die gebraucht wird, um 100g eines Pigments, in diesem Fall der Kieselsäuregele, zu einer zusammenhaftenden, kittartigen Masse zu verarbeiten, die auf einer Glasplatte gerade noch nicht schmiert. Diese Ölzahl wird bestimmt nach der DIN-Norm ISO 787.
Als weitere Kenngröße der erfindungsgemäßen Kieselsäuregele dient die mittlere Partikelgröße. Sie beträgt 1 - 10 µm, bevorzugt 2 - 8 µm.
Desweiteren ist das Porenvolumen maßgebend. Es beträgt 1.2 - 2.0ml/g, bevorzugt 1.8ml/g.
Ein weiters wesentliches Merkmal der erfindungsgemäßen Kieselsäuregele ist ihr Oberflächen-pH-Wert. Er beträgt 2 - 8, bevorzugt 3 - 7.
Die erfindungsgemäß eingesetzten Kieselsäuregele können auch mit organischen Verbindungen nachbehandelt sein.
Die Kieselsäuregele werden in Mengenanteilen von 0.1 - 5, bevorzugt 0.5 - 2 Gew.% bezogen auf die nichtflüchtigen Bestandteile des Gemischs, verwendet.

Als erfindungsgemäße polymere Bindemittel eignen sich z.B. Polymere mit seitenständigen Carboxyl- oder Carbonsäureanhydrid. Besonders bevorzugt werden Copolymere der Acryl- und Methacrylsäure, die als Comonomere Acryl- oder Methacrylsäureester, Styrole, Acryl- oder Methacrylnitrile, Acryl- oder Methacrylamide oder Vinylheterocyclen enthalten. Als (Meth)acrylsäureester werden Alkylester mit vorzugsweise 1 - 10, insbesonders 1- 7 Kohlenstoffatomen, in der Alkylgruppe eingesetzt. Der Anteil des polymeren Bindemittels im Gemisch beträgt im allgemeinen 15 - 50, vorzugsweise 20 - 40 Gew.-% bezogen auf die nichtflüchtigen Bestandteile des Gemischs.

Als photopolymerisierbare Monomere werden im allgemeinen Ester der Acryl- oder Methacrylsäure verwendet. Der Alkohol sollte vorzugsweise zwei Hydroxygruppen enthalten, da durch mehrfach ungesättigte Verbindungen die erwünschte Vernetzungswirkung erreicht wird. In untergeordneten Mengen können auch Ester von einwertigen Alkoholen im Gemisch enthalten sein. Beispiele für geeignete Alkohole sind Ethylenglykol, Propylenglykol, Butandiol-1,4, Diethylenglykol Oligopropylenglykole, Trimethylolpropan, Pentaerythrit, Dipentaerythrit und Bisphenol-A-bishydroxyethylether. Besonders vorteilhaft sind Acrylate und Methacrylate mit Dipentaerythrit, Bisphenol-A-bishydroxyethylether, Trimethylolpropan und die mit Schwefelwassserstoff oligomerisierten Ester linearer oder verzweigter, aliphatischer, mehrwertiger Alkohole, insbesondere des Trimethylolpropans. Die Monomere sind im allgemeinen in einer Menge von 10 - 35, vorzugsweise 15 - 30 Gew.-%, bezogen auf den Gesamtgehalt an nichtflüchtigen Bestandteilen in dem Gemisch enthalten.

Das erfindungsgemäße Gemisch enthält ferner eine oder mehrere Verbindungen mit mindestens zwei thermisch reaktiven Gruppen wie z.B.Epoxygruppen, Isocyanatgruppen oder an einem Stickstoffatom eines offenkettigen oder cyclischen Säureamids oder an einem aromatischen Kohlenstoffatom gebundene Gruppen der Formel -CH2-O-R, worin R ein Wasserstoffatom, eine niedere Alkyl, Acyl- oder Hydroxyalkylgruppe ist. Bevorzugt werden zwei- oder mehrwertige Epoxyverbindungen.verwendet. Als Beispiele sind insbesondere Bisglycidylether von zweiwertigen Alkoholen und Phenolen, z.B. Bisphenol-A und Polyethylenglykol oder Polypropylenglykolethern des Bisphenols-A geeignet. Auch Bisglycidylether von dreiwertigen Alkoholen, z.B. von Glycerin, können verwendet werden. Die thermischen Härter werden dem Gemisch in einer Menge von etwa 5 - 30, bevorzugt 10 - 20 Gew.-% bezogen auf die nichtflüchtigen Bestandteile des Gemischs zugesetzt.

Das erfindungsgemäße Gemisch enthält zusätzlich einen Photoinitiator und/oder einen Sensibilisator wie z.B. α-Halogenacetophenone, Benzile, Benzoine oder deren Ether, Benzophenone, Benzilacetale, Anthrachinone, Thioketone, Thioxanthone und Acridine. Als Sensibilisatoren seien Bromoform, 2,4-Dinitrotoluol und Triphenylmethanfarbstoffe genannt. Die Photoinitiatoren werden im allgemeinen in Mengenanteilen von 0.1 - 15, vorzugsweise von 0.5 - 10 Gew.-% bezogen auf die nichtflüchtigen Bestandteile des Gemischs zugesetzt.

Eine weitere Komponente des photopolymerisierbaren Gemischs ist ein Füller wie z.B. Glimmer, Calciumcarbonat, Aluminiumsilikat, Aluminiumoxide, Talk, Titandioxid, Bariumsulfat oder Antimontrioxid. Bevorzugt wird Talk verwendet. Die Menge des Füller beträgt üblicherweise 5 - 40, bevorzugt 15 - 30 Gew-% bezogen auf die nichtflüchtigen Bestandteile des Gemischs.

Das photopolymerisierbare Gemisch enthält außerdem Gießhilfsmittel wie z.B. Polycarbonsäuren, Polyamide, Polysiloxane oder Polyurethane. Bevorzugt werden Polysiloxane verwendet. Die Menge der Gießhilfsmittel beträgt üblicherweise 0.01 - 1, bevorzugt 0.01 - 0.1 Gew-% bezogen auf die nichtflüchtigen Bestandteile des Gemischs.

Das Gemisch kann ggf. eine Reihe weiterer üblicher Zusätze enthalten, z.B. Farbstoffe, Stabilisatoren, Pigmente, Weichmacher, Sensibilisatoren, Flammschutzmittel und Härter.

Geeignete Lösungsmittel für die Herstellung der Gießlösungen sind z.B. Diethylketon, Diisobutylketon, Cyclohexanon, Glykol- und Propylenglykolether, -ester und -etherester und die entsprechenden Polyethylenglykol- bzw.

Polypropylenglykolverbindungen wie z.B. Methylglykol, Triethylenglykolmonoethyl- oder -monobutylether, Diethylenglykoldiethylether, Ethylenglykolmonoacetat oder Propylenglykolmethyletheracetat. Die Menge des verwendeten Lösungsmittels richtet sich nach der gewünschten Viskosität des Beschichtumgsgemischs, die bevorzugt zwischen 200 und 1 200, insbesondere 500 und 800, besonders bevorzugt zwischen 400 und 600 mPas beträgt.

Da das erfindungsgemäße Gemisch in der verarbeitungsfertigen Form nur begrenzt haltbar ist, wird es in Form von drei Gebinden aufbewahrt. Bevorzugt wird so verfahren, daß alle Komponenten mit Ausnahme der thermisch reaktiven Verbindung und des Mattierungsmittels in einer Hauptmischung vorliegen, der kurz vor der Verarbeitung erst der thermische Härter und dann das Mattierungsmittel beigemischt werden.

Der Auftrag des photopolymerisierbaren Gemischs auf die Leiterplatten erfolgt z.B. mittels Vorhanggießen, Sprühen, elektrostatisches Sprühen oder Siebdruck.

Das erfindungsgemäße photopolymerisierbare Gemisch wird bevorzugt mittels einer handelsüblich Vorhanggießmaschine als kontinuierlich vertikal laufender Flüssigkeitsfilm auf die mittels eines Förderbandes unter diesen Film durchgeführte Leiterplatte aufgebracht wie es in der EP-B 00 02 040 beschrieben ist. Die so hergestellten Schichten werden durch trocknen, z.B. in einem IR-Trockner oder einem Trockenschrank vom Lösungsmittel befreit. Die so beschichtete Leiterplatte wird dann durch eine Vorlage belichtet, die die Teile der Platte vor der Belichtung schützt, die für den Lötvorgang frei bleiben müssen.

Als aktinische Strahlung kommt jede elektromagnetische Strahlung in Betracht, deren Energie zur Anregung eines geeigneten Polymerisationsinitiators ausreicht. Geeignet ist insbesondere sichtbares und ultraviolettes Licht, Röntgen- und Elektronenstrahlung. Bevorzugt wird kurzwelliges, sichtbares und nahes UV-Licht.

Die Entwicklung der bildmäßig belichteten Schichten erfolgt bevorzugt mit wässrigen, vorzugsweise wässrig-alkalischen Lösungen. Die entwickelten Lötstopmasken werden dann einer Temperaturbehandlung unterzogen, die üblicherweise zwischen 10 - 120 Minuten bei 80 -180° C durchgeführt wird.

Die erhalten gedruckten Schaltungen weisen Schutzschichten auf, die die an sie gestellten Anforderungen erfüllen. Die Schichten weisen eine matte Oberfläche auf, die keine Gießdefekte zeigt. Die elektrischen Eigenschaften sind nicht vermindert und die Beständigkeit gegenüber dem Lötbad ist sehr gut.

Die folgenden Beispiele sollen die Erfindung verdeutlichen, wobei die Beispiele 1 und 7 keine Ausführungsform der Erfindung darstellen. Die angegebenen Prozente und Teile beziehen sich auf das Gewicht.

### Beispiel 1

Es wurde ein photopolymerisierbares Gemisch aus 30.2 g eines Copolymeren auf Polymethylmethacrylatbasis mit einer Säurezahl von 110, 33.2 g einer Monomermischung aus Dipentaerythritpentaacrylat, mit Schwefelwasserstoff oligomerisiertes Trimethyloltriacrylat und einem Diacrylat eines Bisphenol-A-diglycidylethers, 6.7 g einer Photoinitiatormischung, 20 g Talk, 0.4 g eines grünen Pigments, 0.3 g eines Polysiloxans und 9.2 g Bisphenol-A-diglycidylether in Propylenglykolmethyletheracetat hergestellt, wobei die Epoxyverbindung als letzte Komponente zugegeben wurde. Die Viskosität der Gießlösung betrug 600 mPas.
Diese Gießlösung wurde mittels eines handelsüblichen Vorhanggießers bei üblichen Gießbedingungen auf eine Leiterplatte aufgebracht und anschließend bei 80° C 20 Minuten getrocknet. Die Filmbildung war nicht ausreichend, und man erhielt eine glänzende Filmoberfläche (90 %).
Die so erhaltene photopolymerisierbare Schicht wurde dann durch eine Filmvorlage belichtet und mit einer wäßrigen alkalischen Entwicklerlösung ausgewaschen.
Die mit dieser Lötstopmaske versehene Leiterplatte wurde anschließend einem üblichen Lötprozeß unterworfen, wobei die Beständigkeit der Lötstopmaske gegenüber dem Lötbad gut war, und die geforderten Isolationseigenschaften erfüllt wurden.

### Beispiel 2

Zu einer nach Beispiel 1 hergestellten Gießlösung wurden 1.5 g eines organisch behandelten Kieselsäuregels mit einer Ölzahl von 300 g/100 g, einer mittleren Partikelgröße von 4 µm, einem Porenvolumen von 1.8 ml/g und einem Oberflächen-pH-Wert von 3 zugegeben, und das photopolymerisierbare Gemisch dann wie in Beispiel 1 beschrieben auf eine Leiterplatte aufgebracht. Die Filmbildung war gut, es traten keine Bénar-Zellen oder Bläschen auf, und man erhielt eine Lötstopmaske mit einer matten Oberfläche (Reflektion 45 %), die die geforderten Isolationseigenschaften aufweist und im Lötprozeß stabil ist.

### Beispiel 3

Zu einer nach Beispiel 1 hergestellten Gießlösung wurden 2 g eines Kieselsäuregels mit einer Ölzahl von 320 g/100 g, einer mittleren Partikelgröße von 5 µm, einem Porenvolumen von 1.8 ml/g und einem Oberflächen-pH-Wert von 7 zugegeben, und das photopolymerisierbare Gemisch dann wie in Beispiel 1 beschrieben auf eine Leiterplatte aufgebracht. Die Filmbildung war sehr gut, es traten keine Bénard-Zellen oder Bläschen auf, und man erhielt eine Lötstopmaske mit einer matten Oberfläche (Reflektion 55 %), die die geforderten Isolationseigenschaften aufweist und im Lötprozeß stabil ist.

### Beispiel 4

Zu einer nach Beispiel 1 hergestellten Gießlösung wurden 1 g eines Kieselsäuregels mit einer Ölzahl von 320 g/100 g, einer mittleren Partikelgröße von 3 µm, einem Porenvolumen von 1.8 ml/g und einem Oberflächen-pH-Wert von 7 zugegeben, und das photopolymerisierbare Gemisch dann wie in Beispiel 1 beschrieben auf eine Leiterplatte aufgebracht. Die Filmbildung war sehr gut, es traten keine Benhart-Zellen oder Bläschen auf, und man erhielt eine Lötstopmaske mit einer matten Oberfläche (Reflektion 60 %), die die geforderten Isolationseigenschaften aufweist und im Lötprozeß stabil ist.

### Beispiel 5

Zu einer nach Beispiel 1 hergestellten Gießlösung wurden 1.5 g eines Kieselsäuregels mit einer Ölzahl von 300 g/100 g, einer mittleren Partikelgröße von 4 µm, einem Porenvolumen von 1.8 ml/g und einem Oberflächen-pH-Wert von 3 zugegeben, und das photopolymerisierbare Gemisch dann wie in Beispiel 1 beschrieben auf eine Leiterplatte aufgebracht. Die Filmbildung war gut, es traten keine Benhart-Zellen oder Bläschen auf, und man erhielt eine Lötstopmaske mit einer matten Oberfläche (Reflektion 50 %), die die geforderten Isolationseigenschaften aufweist und im Lötprozeß stabil ist.

### Beispiel 6

Zu einer nach Beispiel 1 hergestellten Gießlösung wurden 1.5 g einer pyrogenen Kieselsäure mit einer Ölzahl von 360 g/100 g, einer mittleren Partikelgröße von 4 µm und einem Oberflächen-pH-Wert von 6 - 7 zugegeben, und das photopolymerisierbare Gemisch dann wie in Beispiel 1 beschrieben auf eine Leiterplatte aufgebracht. Man erhielt zwar eine Lötstopmaske mit einer matten Oberfläche (Reflektion 55 %), die Filmbildung war jedoch mangelhaft.

### Beispiel 7

Zu einer nach Beispiel 1 hergestellten Gießlösung wurden 1.5 g einer gefällten Kieselsäure mit einer Ölzahl von 230 g/100 g, einer mittleren Partikelgröße von 3 µm und einem Oberflächen-pH-Wert von 5 - 7 zugegeben, und das photopolymerisierbare Gemisch dann wie in Beispiel 1 beschrieben auf eine Leiterplatte aufgebracht. Man erhielt zwar eine Lötstopmaske mit einer matten Oberfläche (Reflektion 60 %), die Filmbildung war jedoch ungenügend

## Patentansprüche

1. Photopolymerisierbares Gemisch zur Herstellung von Lötstopmasken, enthaltend
a) mindestens ein polymeres Bindemittel,
b) mindestens ein photopolymersierbares Monomer mit mindestens einer ethylenisch ungesättigten Gruppe,
c) mindestens einen Photoinitiator,
d) mindestens eine Verbindung mit mindestens zwei thermisch reaktiven Gruppen,
e) mindestens einen Füller,
f) mindestens ein Gießhilfsmittel und
g) mindestens ein siliciumdioxydhaltiges Mattierungsmittel
dadurch gekennzeichnet, daß
als Mattierungsmittel mindestens ein Kieselsäuregel mit einer Ölzahl gemäß DIN-Norm ISO 787 von 200 - 360 g/100g, einer mittleren Partikelgröße von 1 - 10 µm, einem Porenvolumen von 1.2 - 2.0 ml/g und einem Oberflächen-pH-Wert von 2-8 verwendet wird.

2. Photopolymerisierbares Gemisch nach Anspruch 1,
dadurch gekennzeichnet, daß
0.1 - 5 Gew.-% des Kieselsäuregels verwendet werden.

3. Photopolymerisierbares Gemisch nach Anspruch 1 oder 2,
dadurch gekennzeichnet, daß
das Kieselsäuregel eine Ölzahl gemaß DIN-Norm ISO 787 von 300 - 340 g/100g aufweist.

4. Photopolymerisierbares Gemisch nach einem der Ansprüche 1-3,
dadurch gekennzeichnet, daß
das Kieselsäuregel eine mittlere Partikelgröße von 2 - 8 µm aufweist.

5. Photopolymerisierbares Gemisch nach einem der Ansprüche 1 - 4,
dadurch gekennzeichnet, daß
das Kieselsäuregel ein Porenvolumen von 1.8 ml/g aufweist.

6. Photopolymerisierbares Gemisch nach einem der Ansprüche 1 - 5,
dadurch gekennzeichnet, daß
das Kieselsäuregel einen Oberflächen-pH-Wert von 3 - 7 aufweist.

7. Photopolymerisierbares Gemisch nach einem der Ansprüche 1 - 6,
dadurch gekennzeichnet, daß
als Bindemittel Copolymere aus Acrylaten und/oder Methacrylaten verwendet werden.

8. Photopolymerisierbares Gemisch nach einem der Ansprüche 1 - 7,
dadurch gekennzeichnet, daß
als Monomere Acrylsäure- und/oder Methacrylsäureester mit Bisphenol-A-bishydroxyethylethern und/oder mit Dipentaerythrit und/oder mit Trimethylolpropan verwendet werden und/oder Acrylsäure- und/oder Methacrylsäureester mit linearen oder verzweigten aliphatischen, mehrwertigen Alkoholen mit 4 - 12 Kohlenstoffatomen verwendet werden, die mit Schwefelwasserstoff oligomerisiert wurden.

9. Photopolymerisierbares Gemisch nach einem der Ansprüche 1 - 8,
dadurch gekennzeichnet, daß
als Füller Talk verwendet wird.

10. Photopolymerisierbares Gemisch nach einem der Ansprüche 1 - 9,
dadurch gekennzeichnet, daß
als Gießhilfsmittel ein oder mehrere Polysiloxane verwendet werden.

11. Photopolymerisierbares Gemisch nach einem der Ansprüche 1 - 10,
dadurch gekennzeichnet, daß
als Verbindung mit mindestens zwei thermisch reaktiven Gruppen Bisglycidylether von Bisphenol-A und/oder von Polyethylenglykol- und/oder Polypropylenglykolethern des Bisphenol-A verwendet werden.

12. Verfahren zur Herstellung einer Lötstopmaske,
dadurch gekennzeichnet, daß
eine Lösung eines photopolymerisierbaren Gemischs nach Anspruch 1 herstellt wird, indem die Komponenten a), b), c), e) und f) miteinander gemischt werden, dann die Komponente d) und schließlich die Komponente g) zugeben werden, diese Lösung auf die Oberfläche einer gedruckten Schaltung aufgebracht und getrocknet wird, die so hergestellte Schicht bildmäßig mit aktinischer Strahlung unter Aussparung der Lötaugen bestrahlt, die unbestrahlten Schichtbereiche mit einem Entwickler ausgewaschen und die Schicht getrocknet wird und die Lötstopmaske in beliebiger Reihenfolge thermisch nachbehandelt und mit aktinischer Strahlung bestrahlt wird.

## Claims

1. Photopolymerizable composition for the preparation of solder masks comprising
a) at least one polymeric binder,
b) at least one photopolymerizable monomer with at least one ethylenically unsaturated group
c) at least one photoinitiator,
d) at least one compound with at least two thermally reactive groups,
e) at least one filler,
f) at least one coating aid and
g) at least one silica containing matting agent
characterized in that,
at least one silica gel with an oil number according to DIN ISO 787 of 200 - 360 g/100g, an average particle size of 1 - 10 µm, a pore volume of 1.2 - 2.0 ml/g, and a surface pH-value of 2 - 8 is used as matting agent.

2. Photopolymerizable composition according to claim 1
characterized in that,
0.1 - 5 percent by weight of silica gel are used.

3. Photopolymerizable composition according to claim 1 to 2
characterized in that,
the silica gel has an oil number according to DIN ISO 787 of 300- 340 g/100g.

4. Photopolymerizable composition according to claim 1 to 3
characterized in that,
the silica gel has an average particle size of 2 - 8 µm.

5. Photopolymerizable composition to claim 1 to 4
characterized in that,
the silica gel has a pore volume of 1.8 ml/g.

6. Photopolymerizable composition according to claim 1 to 5
characterized in that,
the silica gel has a surface pH-value of 3 - 7.

7. Photopolymerizable composition according to claim 1 to 6
characterized in that,
copolymers of acrylates and/or methacrylates are used as binders.

8. Photopolymerizable composition according to claim 1 to 7
characterized in that,
acrylic acid and/or methacrylic acid esters with bisphenol-A bishydroxyethyl ethers and/or with dipentaerythritol and/or with trimethylol propane are used as monomers, and/or acrylic acid and/or methacrylic acid esters with linear or branched aliphatic, alcohols with 4- 12 carbon atoms are used which have been oligomerized with hydrogen sulfide.

9. Photopolymerizable composition according to claim 1 to 8
characterized in that,
talc is used as filler.

10. Photopolymerizable composition according to claim 1 to 9
characterized in that,
one or more polysiloxanes are used as coating aid.

11. Photopolymerizable composition according to claim 1 to 10
characterized in that,
bisglycidylethers of bisphenol-A and/or of polyethyleneglycol- and/or polypropyleneglycolethers of bisphenol-A are used as compound with at least two thermally reactive groups.

12. Process for the preparation of solder masks,
characterized in that,
a solution of the photopolymerizable composition according to claim 1 is prepared, wherein components a), b), c), e) and f) are mixed, then component d) and at last component g) are added, this solution is coated onto the surface of a printed circuit and dried, the so prepared layer is imagewise exposed with actinic radiation with leaving open the solder eyes, the unexposed areas are washed out with a developer and the layer is dried, and the solder mask is, irrespective of sequence, thermally treated and exposed with actinic radiation.

## Revendications

1. Mélange photopolymérisable pour la production de réserves de soudage, comprenant
a) au moins un liant polymère,
b) au moins un monomère photopolymérisable avec au moins un groupement éthyléniquement insaturé,
c) au moins un photoinitiateur,
d) au moins un composé ayant au moins deux groupements thermiquement réactifs,
e) au moins une matière de charge,
f) au moins un addditif de coulée et
g) au moins un agent de matage contenant du dioxyde de silicium
caractérisé en ce qu'au moins un gel de silice ayant un indice d'absorption d'huile selon la norme D.I.N. ISO 787 de 200-360 g/100g, une taille de particules moyenne de 1-10 µm, un volume de pores de 1,2-2,0 ml/g et une valeur de pH de surface de 2-8, est utilisé en tant qu'agent de matage.

2. Mélange photopolymérisable selon la revendication 1, caractérisé en ce que 0,1-5 % poids du gel de silice est utilisé.

3. Mélange photopolymérisable selon la revendication 1 ou 2, caractérisé en ce que le gel de silice a un indice d' absorption d'huile selon la norme D.I.N. ISO 787 de 300-340 g/100g.

4. Mélange photopolymérisable selon une des revendications 1-3, caractérisé en ce que le gel de silice a une taille de particules moyenne de 2-8 µm.

5. Mélange photopolymérisable selon une des revendications 1-4, caractérisé en ce que le gel de silice a un volume de pores de 1,8ml/g.

6. Mélange photopolymérisable selon une des revendications 1-5, caractérisé en ce que le gel de silice a une valeur de pH de surface de 3-7.

7. Mélange photopolymérisable selon une des revendications 1-6, caractérisé en ce que des copolymères d'acrylates et/ou de méthacrylates sont utilisés entant que liant.

8. Mélange photopolymérisable selon une des revendications 1-7, caractérisé en ce que des esters d'acide acrylique et/ou d'acide méthacrylique avec des éthers de bisphenol A et de dihydroxyethyle et/ou avec du dipentaérythrol et/ou du triméthylolpropane et/ou des esters d'acide acrylique et/ou d'acide méthacrylique avec des polyalcohols aliphatiques linéaires ou ramifiés avec 4-12 atomes de carbone, ayant été oligomérisés avec du sulfure d'hydrogène, sont utilisés en tant que monomères.

9. Mélange photopolymérisable selon une des revendications 1-8, caractérisé en ce que du talc est utilisé en tant que matière de charge.

10. Mélange photopolymérisable selon une des revendications 1-9, caractérisé en ce qu'un ou plusieurs polysiloxanes est (sont) utilisé(s) en tant qu'additif de coulée.

11. Mélange photopolymérisable selon une des revendications 1-10, caractérisé en ce que des éthers de diglycidyle et de bisphénol A et/ou des éthers de polyéthylène glycol et/ou de polypropylène glycol et de bisphenol A sont utilisés en tant que composé ayant au moins deux groupements thermiquement réactifs.

12. Procédé de préparation d'une réserve de soudage, caractérisé en ce qu'une solution d'un mélange photopolymérisable selon la revendication 1 est préparée en mélangeant ensemble les composants a), b), c), e) et f), en ajoutant ensuite le composant d) et enfin le composant g), en appliquant cette solution à la surface d'un cicuit imprimé et en la laissant sécher, en irradiant la couche ainsi préparée selon une image avec de la radiation actinique en épargnant les zones de contact de soudage, en rinçant les zones de la couche non-irradiées avec un agent développant et en laissant sécher la couche et, en effectuant dans un ordre quelconque, un post-traitement thermique et une irradiation avec de la radiation actinique.
